# EUROPEAN PATENT APPLICATION

(11) **EP 1 184 763 A1**
(43) Date of publication of application: **06.03.2002**
(21) Application number: 00118408.4
(22) Date of filing: 24.08.2000
(51) Int. Cl.: G05B 19/418, H01L 21/00

(54) **Arrangement for data transmission between an equipment for manufacturing of a semiconductor device and a communicating device and method for operating the arrangement**

(71) Applicant: Infineon Technologies SC300 GmbH & Co. KG, 01099 Dresden (DE)
(72) Inventor: Walter, Ricco, 01097 Dresden (DE); Marx, Eckhard, 01471 Radeburg (DE)
(74) Representative: Fischer, Volker, Dipl.-Ing.

(57) **Abstract**

An arrangement for data transmission comprises an equipment (3) for manufacturing of a semiconductor device in a manufacturing process with an integrated measurement tool (5) for producing measurement data (30) correlating to the manufacturing process. A communicating device (2) performs a data exchange of logistic and process data (20) with the equipment (3) via a bus system (1) by means of a standardized data communication protocol. A measurement application system (6) is connected to the bus system (1) via a bus system hub (4) for sniffing exchanged logistic and process data (20) and to the measurement tool (5) for capturing produced measurement data (30). The measurement application system (6) is applicable for assigning the measurement data (30) to correlating logistic and process data (20). As a result, the measurement application system (6) and measurement tool (5) can easily be integrated into an existing bus system network (1) with one or more manufacturing equipments (3, 11, 12) connected to the network.

## Description

The present invention relates to an arrangement for data transmission comprising an equipment for the manufacturing of a semiconductor device in a manufacturing process with an integrated measurement tool for producing measurement data correlating to the manufacturing process and at least one communicating device performing a data exchange of logistic and process data with the equipment by means of a standardized data communication protocol via a bus system and to a method for operating such an arrangement.

In the technical field of the manufacturing of semiconductor devices, especially semiconductor chips produced out of semiconductor wafers, it is common and necessary to apply various process steps to the wafers. Therefore, different equipment is usually used with each piece of equipment performing a different process. To this end, it is common to connect each piece of equipment to a fabrication network performing a data exchange between the equipment and, e.g., a central host system for controlling each piece of equipment. The pieces of equipment and the central host system are therefore applicable to communicate with each other and to exchange, e.g., logistic and process related data.

Equipment for manufacturing of semiconductor wafers is often supplied with subsequently inserted measurement tools such as process sensors and/or wafer measurement equipment performing a so-called metrology system. These subsequently integrated process sensors and wafer measurement equipment, which produce measurement data correlating to the current manufacturing process, have to be integrated with respect to the data exchange flow between the manufacturing equipment and the host system, especially if the measurement data have to be evaluated together with correlating and assigned logistic or process data by the user or a controlling computer system.

To establish an effective and a well-coordinated data exchange, standardized fabrication networks and data communication protocols are often used (e.g. SECS 2 protocol on ethernet bus systems). Integrating a measurement equipment subsequently into the standardized data exchange flow usually leads to a subsequent change or amendment of the manufacturing equipment interface control and/or a change of the host system interface control, for instance if a measurement application system for means of combining and evaluating measurement data and correlating logistic and process data simply is inserted into the data flow of the fabrication network. Therefore, expensive and time-intense adaptation work is necessary for each type of measurement tool and manufacturing equipment. Such an adaptation of software and/or hardware means a risky intervention into a running system with the effect of an unscheduled downtime of the whole fabrication network. Further, if the measurement application system doesn't work properly in case of a device failure, the whole data flow of the fabrication network could be affected. Additionally, a time delay of the communication between host system and manufacturing equipment affected by the measurement application system is possible.

In view of the prior art it is an object of the present invention to provide an arrangement for data transmission of the above-mentioned type, the arrangement comprising a measurement application system which can be easily integrated into a standardized fabrication communication bus system or network.

Further, it is an object of the present invention to provide a method for operating such an arrangement.

The object concerning the arrangement is solved by an arrangement for data transmission of the above-mentioned type further comprising a bus system connected to the equipment and to the communicating device for establishing the data exchange between the equipment and the communicating device, and comprising a measurement application system being connected to the bus system via a bus system hub for sniffing logistic and process data exchanged between the equipment and the communicating device, the measurement application system being connected to the measurement tool for capturing produced measurement data, the measurement application system being applicable for assigning the measurement data to correlating logistic and process data.

The object concerning the method is solved by a method for operating an arrangement according to the invention, wherein the measurement data are assigned to the correlating logistic and process data in real time acquisition.

With an arrangement according to the invention a secure, easy, fast and cost effective combination of logistic and process data exchanged between the manufacturing equipment and the communicating device with data from a subsequently integrated measurement tool is made possible. Since the measurement application system is connected to the bus system or fabrication network via a bus system hub or respective network hub for a sniffing of logistic and process data exchanged between the equipment and the communicating device, a change of the running system between the equipment and the communicating device is not necessary.

The bus system, for example, is designed as a fabrication network system connected to further manufacturing equipment. The communicating device, for example, is designed as a central host system in a fabrication network for controlling the manufacturing equipment. For instance, the various pieces of manufacturing equipment can communicate with each other and in particular can communicate with the central host system.

With an arrangement according to the invention, no change of network addresses for the central host system and each of the manufacturing equipment has to be made when process sensors and/or wafer measurement equipment are integrated subsequently into manufacturing equipment. By using a bus system hub or network hub no adaptation work for e.g. changing the host system interface control or equipment interface control is necessary. In case of a system-crash, switch-off or disconnection of the measurement application system no impact on the data communication between the manufacturing equipment and the communicating device is given. The arrangement according to the invention enables a multiple and versatile adaptation to different kinds of manufacturing equipment by suitable configuration. According to the invention, several measurement application systems can easily be integrated into an existing standardized fabrication communication network. Therefore, a cost effective subsequent insertion of sensors or metrology equipment is possible.

According to the invention, a real time assignment of produced measurement data to correlating process and logistic data is made possible. For instance, the measurement and/or the correlating logistic and process data are monitored by means of the measurement application system. Further, it is possible to use the assigned measurement data and logistic and process data for a closed-loop controlling of a manufacturing process.

According to an embodiment of the present invention, the measurement application system comprises a filtering unit for filtering needed logistic and process data from unneeded logistic and process data. Preferably, the user can configure the filtering unit by laying down suitable rules for selection of needed logistic and process data. Therefore, the filtering unit is configurable via an external terminal of the measurement application system.

In a further preferred embodiment, the measurement application system comprises a converting unit for adapting the logistic and process data, so that the logistic and process data can be processed with the measurement data. Thus, metrology or process sensor data received from the measurement application system over suitable digital or analog interfaces from integrated process sensors and integrated wafer measurement equipment can be combined with the corresponding logistic and process data. Advantageously, the converting unit has an open data interface which is freely adaptable to applications for assignment of logistic and process data, which are exchanged by means of a standardized data communication protocol, to corresponding measurement data. Preferably, the converting unit can be configured by the user. Therefore, the converting unit is configurable via an external terminal of the measurement application system.

Both the filtering unit and the converting unit can be realized by a suitable configuration of hardware or by appropriate software in connection with a data processor in the measurement application system. The measurement application, for example, can run on standard industrial personal computers performing a measurement application system.

In a further preferred embodiment, the measurement application system comprises a communication interface connected to the bus system for sniffing the logistic and process data, the communication interface being configurable via an external terminal of the measurement application system. Thus, the user can configure the communication interface by declaring addresses for each device connected to the bus system, so-called IP addresses, an IP port number and a session identifying number, a so-called session ID of the logistic and process data communication.

Further advantageous embodiments of the invention are evident from the dependent claims.

The invention can be better understood by reference to the following description of embodiments of the invention taken in conjunction with the accompanying drawings, wherein
- Figure 1: shows a functional block diagram of an arrangement according to the invention,
- Figure 2: shows a diagram of a data flow performed in the measurement application system.

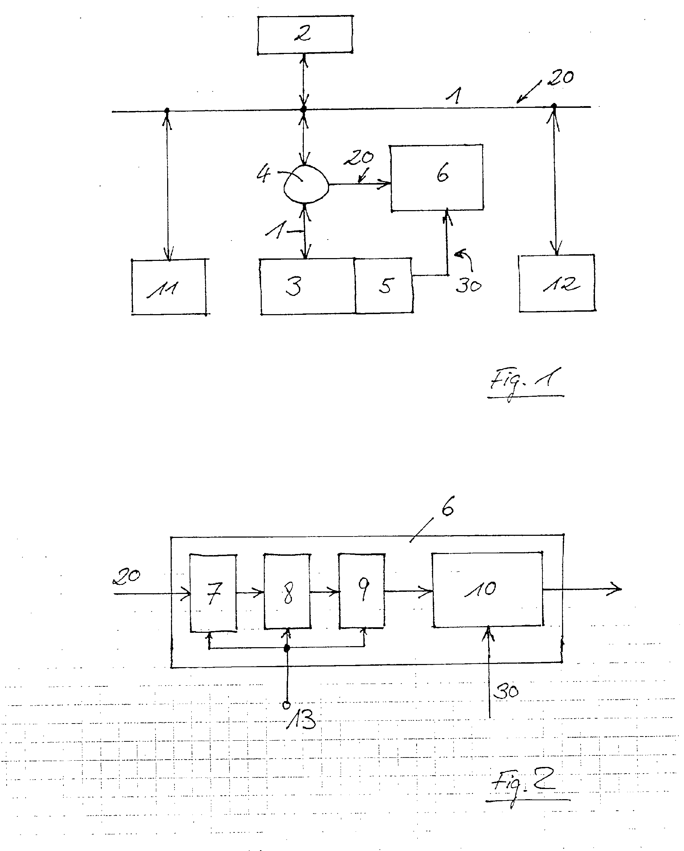

Figure 1 schematically illustrates an embodiment of an arrangement according to the present invention by means of a functional block diagram. The arrangement comprises an equipment 3 for manufacturing of a semiconductor device such as a semiconductor wafer in a manufacturing process. In the equipment 3, a measurement tool 5 such as process sensors and wafer measurement equipment is integrated for producing measurement data which correlate to the current manufacturing process performed in or by the equipment 3. The equipment 3 is connected to the bus system or fabrication network 1 as well as the host system 2. Further equipment 11 and 12 are connected to the fabrication network 1. Between the central host system 2 and the pieces of equipment 3, 11 and 12 a data exchange of logistic and process data 20 is performed. For data exchange a standardized communication protocol is used, in the field of manufacturing of semiconductor devices typically a so-called SECS 2 protocol (Semiconductor Equipment Communications Standard, SEMI E5).

The arrangement further comprises a measurement application system 6 which is connected to the fabrication network 1 via a network hub 4. The measurement application system 6 is further connected to the measurement tool 5 integrated in the manufacturing equipment 3 for capturing measurement data 30 produced by the measurement tool 5. Via the network hub 4 logistic and process data 20 (SECS information) exchanged between e.g. the host system 2 and the equipment 3 can be sniffed by the measurement application system 6. The measurement tool 5 is connected to the measurement application system 6 via a direct line for establishing a direct exchange of measurement data 30 between tool 5 and the measurement application system 6.

A combination of SECS information from host-equipment communication with corresponding measurement data received from the integrated process sensors and integrated wafer measurement equipment is established in the measurement application system 6. In the measurement application system 6 the measurement data 30 are assigned to correlating logistic and process data 20. To this end, logistic and process information according to SECS standard is transmitted and located in the network 1. Data communication based on data exchange of SECS information between e.g. communication partner 2 and e.g. communication partner 3 can be sniffed via the network hub 4 by using a standard network adapter and appropriate software in the measurement application system 6. For instance, the measurement application can run on a standard industrial personal computer like National Instruments'™ PXI™ system with PXI™ cards for analog and digital interfaces and can be connected to the fabrication network 1. Process sensor data or metrology data 30 are received via interfaces from integrated process sensors or respective integrated wafer measurement equipment 5.

Figure 2 shows a diagram of a data flow according to an embodiment of the present invention. The data flow comprises the steps of sniffing all SECS messages 20 of the communication e.g. between the host system 2 and the manufacturing equipment 3. The measurement application system 6 comprises a communication interface 7 connected to the fabrication network 1 for sniffing the SECS messages. The measurement application system 6 further comprises a filtering unit 8 for filtering needed SECS messages from unneeded SECS messages. In a next step, the filtered SECS data are adapted in the converting unit 9, so that the adapted SECS data can be processed with the captured measurement data from the measurement tool 5. The measurement data 30 then are assigned to correlating SECS messages in the unit 10.

The shown embodiment of the present invention allows configuration by users. Via the external terminal 13 the user can configure the communication interface 7 by declaring IP addresses of the host system 2 and the manufacturing equipment 3, the session ID and port of SECS communication. The user further can configure the filtering unit 8 by laying down rules for selection of needed SECS messages. The converting unit 9 has a configurable open data interface which is freely adaptable to applications for assignment of SECS messages to corresponding measurement data like National Instruments'™ LabVIEW™. In the converting unit 9, the values transmitted with the SECS messages, for instance, are assigned to alias names and classes in conformity with the configuration made by the user. For the configuration of the filtering unit 8 and the converting unit 9, the external terminal 13 can be used.

The measurement data 30 are assigned to the correlating SECS data 20 in real time acquisition. In principle, the sequence of assignment can be performed in two different ways. For instance, the measurement data are captured in response to a triggering event from the correlating SECS data. Alternatively, the SECS data are sniffed by the measurement application system 6 in response to a triggering event from correlating measurement data.

With an arrangement according to the invention an insitusensor system can be performed. For instance, an insitusensor system is applicable for endpoint or process monitoring. Further, an integrated metrology system can be realized, e.g., for measuring film thickness on a wafer.

With an arrangement according to the invention, in particular the following benefits further can be achieved. Concerning the process security, no expensive disturbance or interruption of the production process when installing a measurement application system is necessary. The communication interfaces of the host system and/or the manufacturing equipment do not need to be changed. The plugging and unplugging of the measurement application system can be established without interruption of the communication between the host system and the manufacturing equipment. Further, a crash or switch-off of the measurement application system has no effect on the communication between the host system and the manufacturing equipment. In the arrangement, standard hardware components for e.g. standard personal computers are usable. By using appropriate software in the measurement application system a flexible and comfortable configuration by the user can be established.

### List of reference signs

- 1: bus system
- 2: communicating device
- 3: equipment
- 4: bus system hub
- 5: measurement tool
- 6: measurement application system
- 7: communication interface
- 8: filtering unit
- 9: converting unit
- 10: unit
- 11: equipment
- 12: equipment
- 13: external terminal
- 20: logistic and process data
- 30: measurement data

## Claims

1. Arrangement for data transmission comprising
- an equipment (3) for manufacturing of a semiconductor device in a manufacturing process with an integrated measurement tool (5) for producing measurement data (30) correlating to the manufacturing process,
- at least one communicating device (2) performing a data exchange of logistic and process data (20) with the equipment (3) by means of a standardized data communication protocol,
- a bus system (1) connected to the equipment (3) and to the communicating device (2) for establishing the data exchange between the equipment (3) and the communicating device (2) ,
- a measurement application system (6) being connected to the bus system (1) via a bus system hub (4) for sniffing logistic and process data (20) exchanged between the equipment (3) and the communicating device (2), the measurement application system (6) being connected to the measurement tool (5) for capturing produced measurement data (30), the measurement application system (6) being applicable for assigning the measurement data (30) to correlating logistic and process data (20).

2. The arrangement according to claim 1,
**characterized in that**
the measurement application system (6) comprises a filtering unit (8) for filtering needed logistic and process data from unneeded logistic and process data.

3. The arrangement according to claim 2,
**characterized in that**
the filtering unit (8) is configurable via an external terminal (13) of the measurement application system (6).

4. The arrangement according to anyone of claims 1 to 3,
**characterized in that**
the measurement application system (6) comprises a converting unit (9) for adapting the logistic and process data (20), so that the logistic and process data (20) are processable with the measurement data (30).

5. The arrangement according to claim 4,
**characterized in that**
the converting unit (9) is configurable via an external terminal (13) of the measurement application system (6).

6. The arrangement according to anyone of claims 1 to 5,
**characterized in that**
the measurement application system (6) comprises a communication interface (7) connected to the bus system (1) for sniffing the logistic and process data (20), the communication interface (7) being configurable via an external terminal (13) of the measurement application system (6).

7. The arrangement according to anyone of claims 1 to 6,
**characterized in that**
the measurement tool (5) is connected to the measurement application system (6) via a direct line for establishing a direct exchange of measurement data (30) between the measurement tool (5) and the measurement application system (6).

8. The arrangement according to anyone of claims 1 to 7,
**characterized in that**
the measurement tool (5) comprises process sensors and/or wafer measurement equipment.

9. The arrangement according to anyone of claims 1 to 8,
**characterized in that**
the bus system (1) is designed as a network system connected to two or more pieces of equipment for manufacturing of a semiconductor device (3, 11, 12).

10. The arrangement according to anyone of claims 1 to 9,
**characterized in that**
the communicating device (2) is designed as a central host system for controlling the equipment (3).

11. Method for operating an arrangement according to anyone of claims 1 to 10,
**characterized in that**
the measurement data (30) are assigned to the correlating logistic and process data (20) in real time acquisition.

12. Method according to claim 11,
**characterized in that**,
the measurement data (30) and/or the correlating logistic and process data (20) are monitored.

13. Method according to claim 11 or 12,
**characterized in that**,
the measurement data (30) are captured in response to a triggering event from the correlating logistic and process data (20).

14. Method according to claim 11 or 12,
**characterized in that**,
the logistic and process data (20) are sniffed in response to a triggering event from correlating measurement data (30).
